(19) Europäisches Patentamt
European Patent Office
Office européen des brevets

(11) **EP 2 367 015 B1**

(12) **FASCICULE DE BREVET EUROPEEN**

(45) Date de publication et mention
de la délivrance du brevet:
**23.04.2014 Bulletin 2014/17**

(51) Int Cl.:
**G01P 15/12** (2006.01) **G01P 15/08** (2006.01)
**B81B 3/00** (2006.01)

(21) Numéro de dépôt: **11157766.4**

(22) Date de dépôt: **10.03.2011**

(54) **Capteur de force a bruit reduit**

RAUSCHARMER KRAFTSENSOR

FORCE SENSOR WITH REDUCED NOISE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **15.03.2010 FR 1051831**

(43) Date de publication de la demande:
**21.09.2011 Bulletin 2011/38**

(73) Titulaire: **Commissariat à l'Énergie Atomique
et aux Énergies Alternatives
75015 Paris (FR)**

(72) Inventeurs:
• **Walther, Arnaud
38000, GRENOBLE (FR)**
• **Jourdan, Guillaume
38000, GRENOBLE (FR)**
• **Robert, Philippe
38000, GRENOBLE (FR)**

(74) Mandataire: **Ilgart, Jean-Christophe et al
BREVALEX
95, rue d'Amsterdam
75378 Paris Cedex 8 (FR)**

(56) Documents cités:
**EP-A1- 2 098 822 EP-A1- 2 098 823**

**Description**

## DOMAINE TECHNIQUE ET ART ANTÉRIEUR

La présente invention se rapporte à un capteur MEMS ou NEMS à bruit réduit.

Le domaine de l'invention est notamment celui des micro/nano-capteurs de forces volumiques ou surfaciques s'exerçant à distance, en particulier les micro/nano-capteurs inertiels, et plus spécifiquement les accéléromètres, ou les capteurs de forces magnétiques ou électrostatiques.

Les accéléromètres MEMS (systèmes microélectromécaniques) ou NEMS (systèmes nanoélectromécaniques) comportent une masse sismique suspendue mise en mouvement sous l'effet d'une accélération. Les accéléromètres dits « piézorésistifs » comportent en outre une jauge piézorésistive sensible aux déplacements de la masse et permettant, à partir de la variation de résistivité, de déterminer l'accélération.

Le document US 2007/0084041 décrit un accéléromètre mettant en oeuvre des jauges piézorésistives, dans lequel la masse mobile est suspendue à l'extrémité d'une poutre encastrée constituant une liaison pivot et les jauges s'étendent parallèlement à la poutre et sont déformées lors du déplacement de la masse. Cette structure permet de bénéficier d'un effet de bras de levier, la force qui s'exerce sur les jauges piézorésistives est alors amplifiée par rapport à la force subie par la masse suspendue due à l'accélération par un facteur dépendant de la géométrie du système.

Le document EP 2 098 823 décrit un accéléromètre ou un accéléromètre vibrant comportant une masse sismique en une seule partie. Le document EP 2 098 822 décrit un gyroscope vibrant comportant une ensemble rigide d'une masse sismique et d'une seconde partie fixée à la masse par des poutres rigides pour augmenter le moment d'inertie de la masse vibrante.

Les accéléromètres à jauges piézorésistives présentent les avantages d'être peu chers, faciles à implémenter et nécessitant une électronique de traitément simple. Néanmoins ils sont difficilement utilisables à basse fréquence. En effet, un type de bruit, dit en 1/f est prédominant à basse fréquence dans les jauges piézorésistives et entraine une réponse très bruitée à basse fréquence et des dérives de biais incompatibles avec certaines applications, C'est pourquoi, dans de nombreux cas, les accéléromètres capacitifs sont préférés.

Le bruit mentionné ci-dessus est appellé « en 1/f » car sa densité spectrale est inversement proportionnelle à la fréquence.

Les sources de bruit dans un accéléromètre à détection par jauge piézorésistive sont :

- le bruit Brownien,
- le bruit Johnson,
- le bruit en 1/f, et
- un bruit du à l'électronique de mesure.

Le bruit prédominant dans les accéléromètres piezorésistifs est le bruit en l/f, car il est intégré sur une bande passante proche de la fréquence nulle.

Le bruit en l/f peut limiter la résolution. En outre, il peut engendrer une dérive de biais.

Dans le document A. Barlian, "Raview: Semiconductor Piezoresistance for Mïcrosystems", Proceedings of the IEEE, vol 97 (3), p 513-552, 2009, il est mentionné que le bruit en 1/f des accéléromètres peut être réduit en agissant sur les paramètres du procédé de fabrication, tels que le dopage ou la température de recuit.

## EXPOSÉ DE L'INVENTION

C'est par conséquent un but de la présente invention d'offrir un capteur MEMS OU NEMS, par exemple un accéléromètre piézorésistif dans lequel le bruit en 1/f est réduit.

Le but précédemment énoncé est atteint par un capteur comportant une masse mobile autour d'une liaison pivot, des moyens de détection du déplacement de la masse mobile, la masse mobile étant en deux parties, l'une des parties étant déplacée à haute fréquence par rapport à l'autre partie, provoquant une variation haute fréquence de la distance entre l'axe de la liaison pivot et le centre de gravité de la partie déplacée à haute fréquence, ce qui permet de réduire le bruit en 1/f.

En effet, Le bruit en 1/f, qui présente une densité spectrale inversement proportionnelle à la fréquence, est dû à une fluctuation de conductivité dans les résistances. Il s'exprime comme suit :

$$V_{\frac{1}{f}}^2 = V_b^2 \frac{\alpha}{Nf} \quad \text{(en } V^2/Hz\text{)}$$

où Vb désigne la tension d'alimentation de la résistance, $\alpha$ est un coefficient phénoménologique dit coefficient de Hooge et N est le nombre de porteurs de charge dans la résistance ; ce bruit est donc d'autant plus critique que le volume de la résistance est faible.

L'accélération varie lentement à une fréquence typiquement inférieure à 100 Hz. En réalisant au sein de la masse mobile, une partie qui est mise en mouvement sous l'effet d'une excitation haute fréquence, on peut générer un signal haute fréquence, en plus du signal basse fréquence. Ce signal haute fréquence permet alors de réduire le bruit en 1/f, qui peut alors n'être plus limitant pour la résolution du capteur.

En d'autres termes, on utilise une masse mobile composite dont une partie est excitable à haute fréquence, l'oscillateur est alors excité par une composante quasi-statique classique et une composante dynamique.

Le capteur de force selon l'invention comporte donc au moins une masse libérée ayant un degré de liberté selon la direction de la force à mesurer et reliée à une partie fixe par au moins un pivot. La masse libérée comprend au moins une partie mobile par rapport au reste de la masse et reliée à cette dernière par au moins un élément de suspension de façon à permettre un déplacement de la partie mobile dans une direction différente de celle de la force à mesurer. Le capteur comporte également des moyens d'excitation haute fréquence de ladite partie mobile, et des moyens de détection de cette force.

La constitution de la partie mobile dépend de la force que l'on cherche à mesurer, il s'agit d'une masse dans le cas de forces d'accélération, ou d'une masse tout ou partie en matériau magnétique dans le cas de forces magnétiques... Il est préférable que les « organes »/matériaux sensibles à la force que l'on veut mesurer se trouvent sur la partie en mouvement à haute fréquence. Ils peuvent aussi se trouver sur l'autre partie.

Le dimensionnement de la partie mobile de la masse et du au moins un élément de suspension est tel que la partie mobile en se déplaçant induit un déplacement du centre de gravité ce qui provoque une modulation du signal dû à la force à mesurer, détectée à la fréquence de déplacement de ladite partie mobile, cette modulation correspond à une composante dynamique de la force.

Le capteur est avantageusement un accéléromètre à détection piézorésistive dans le plan ou à détection hors plan.

La présente invention a alors principalement pour objet un dispositif de détection microélectromécanique ou nanoélectromécanique d'une force selon une direction donnée, selon la revendication 1, comportant un support et au moins une masse sismique apte à se déplacer sous l'effet de la force à mesurer dans la direction de ladite force, et des moyens de détection du déplacement de ladite masse sismique, ladite masse sismique étant articulée par rapport au support par au moins une liaison pivot, et des moyens ou actionneur aptes à faire varier la distance entre l'axe de la liaison pivot et le centre de gravité de l'exercice de la force sur ladite masse sismique.

On entend par centre de gravité de l'exercice de la force, le centre de gravité de la partie sensible de la masse vis-à-vis de la force que l'on veut mesurer. Généralement, ce centre correspond au centre de gravité de la masse mais dans certains cas, notamment lorsque la masse est hétérogène, par exemple dan le cas des capteurs de forces magnétiques, ce centre peut-être différent de celui de la masse.

Les moyens de variation de la distance sont aptes à faire varier celle-ci à haute fréquence.

Ladite masse sismique comporte au moins des première et deuxième parties mobiles l'une par rapport à l'autre, et les moyens comportent des moyens d'excitation aptes à déplacer la deuxième partie de la masse sismique par rapport à la première partie de la masse sismique dans une direction différente de celle de la force à mesurer dite axe d'excitation.

La fréquence d'excitation des moyens d'excitation est par exemple de l'ordre de quelques kHz.

Dans un exemple de réalisation, les moyens d'excitation sont disposés entre la première et la deuxième partie et s'exerce sur la deuxième partie.

Dans un autre exemple de réalisation, les moyens d'excitation sont disposés entre le support et la deuxième partie et s'exerce sur la deuxième partie par l'intermédiaire d'une masse sismique intermédiaire apte à se déplacer uniquement selon l'axe d'excitation.

Par exemple, les moyens d'excitation sont de type électrostatique, piézoélectrique ou magnétique, et les moyens de détection sont de type capacitif, piézoélectrique, magnétique, piézorésistif, fréquentiel... Les moyens de détection peuvent comporter au moins une jauge piézorésistive, et avantageusement deux jauges piézorésistives disposées de part et d'autre de l'axe de la liaison pivot.

Dans un exemple de réalisation, la deuxième partie de la masse sismique est apte à se déplacer dans un plan de la masse sismique, les moyens de suspension étant formés par au moins un ressort se déformant dans le plan.

Dans un autre exemple de réalisation, la deuxième partie de la masse sismique a un mouvement hors du plan de la masse sismique, les moyens de suspension étant formés par au moins un ressort se déformant hors du plan.

Le ressort peut-être formé par une poutre ou un ensemble de poutres.

La première partie forme, par exemple un cadre à l'intérieur duquel est suspendue la deuxième partie.

Le dispositif de détection peut comporter deux masses sismiques comprenant chacune une première et une deuxième parties reliées entre elles et mobiles l'une par rapport à l'autre, les premières parties étant reliées rigidement par un bras, la liaison pivot étant réalisée sur le bras, et les moyens de détection détectant le déplacement dudit bras, les deux deuxièmes parties mobiles se déplaçant en phase entre-elles.

Le dispositif de détection peut, dans un autre exemple de réalisation, comporter une masse sismique présentant au moins des première et deuxième parties mobiles l'une par rapport à l'autre, la liaison pivot étant réalisée sur la première partie, les moyens d'excitation étant disposés entre le support et la deuxième partie et s'exerçant sur celle-ci par l'intermédiaire d'une masse sismique intermédiaire apte à se déplacer uniquement selon l'axe d'excitation, lesdites deux parties étant disposées l'une par rapport à l'autre de sorte que l'axe coupant l'axe de la liaison pivot et passant par le centre de gravité de la masse, en l'absence d'excitation, soit perpendiculaire à la direction de la force à détecter

En outre, la au moins une masse sismique peut être suspendue par une poutre, l'axe de la liaison pivot étant sensiblement orthogonal au plan de dispositif.

La liaison mécanique entre la ou les jauge(s) piézorésistive(s) et la masse sismique se situe avantageusement sur ou au plus près du plan contenant le centre de gravité et l'axe de la liaison pivot.

Dans une variante de réalisation, la masse sismique est suspendue par un arbre de torsion dont l'axe est contenu dans le plan.

Lorsque l'axe de la liaison pivot est inclue dans le plan, la jauge est décalée le long d'une direction orthogonale au plan par rapport à cet axe dans le cas d'une détection piézorésistive.

Le dispositif de détection peut comporter des électrodes de contre-réaction et/ou des électrodes d'ajustement de fréquence de résonance.

La présente invention a également pour objet un accéléromètre formé par un dispositif de mesure de force selon la présente invention.

L'accéléromètre peut comporter des électrodes de compensation de biais en quadrature de type connu de l'état de la technique, sur lesquelles on applique une tension continue et une tension alternative, ladite tension alternative étant à une fréquence double de la fréquence d'excitation.

L'accéléromètre peut être avantageusement mis en oeuvre sous vide.

Ce type de capteurs, utilisant une détection piézo-résistive ou un autre type de mode de détection, présente aussi l'avantage d'être plus robuste aux vibrations de l'environnement (par exemple dans une voiture), puisque le capteur fonctionne à une fréquence à laquelle l'intensité des vibrations parasites de l'environnement est potentiellement faible. Un autre avantage est que ce capteur peut fonctionner sous vide avec une électronique identique à celle d'un gyroscope et donc dans le cas où l'on veut intégrer à la fois des gyroscopes MEMS et des accéléromètres dans une même centrale inertielle, l'utilisation des accéléromètres de la présente invention permet de pouvoir les "packager" sous vide en même temps que les gyroscopes et d'utiliser une électronique identique, par exemple la même électronique qui mesure le signal de chaque capteur l'un après l'autre dans le cas d'un multiplexage temporel.

## BRÈVE DESCRIPTION DES DESSINS

La présente invention sera mieux comprise à l'aide de la description qui va suivre et des dessins en annexe sur lesquels :

- la figure 1A est une vue en perspective de dessus d'un exemple de réalisation d'un dispositif de détection selon la présente invention dans le cas d'une excitation dans le plan et d'une détection dans le plan,
- la figure 1B est une vue de détail de la figure 1A,
- la figure 2A est une vue en perspective de dessus d'un autre exemple de réalisation d'un dispositif de détection selon la présente invention dans le cas d'une excitation hors plan et d'une détection dans le plan,
- la figure 2B est une vue de détail du capteur de la figure 2A,
- la figure 3 est une vue en perspective de dessus d'un exemple de réalisation d'un dispositif de détection selon la présente invention dans le cas d'une détection hors plan et d'une excitation dans le plan,
- la figure 4 est une vue en perspective de dessus d'une variante de réalisation du dispositif de détection de la figure 1 munie d'électrodes de contre-réaction,
- la figure 5A est une vue en perspective de dessus d'un exemple de réalisation d'un dispositif de détection selon la présente invention robuste à la force de Coriolis et aux effets de la composante quasi-statique de l'accélération,
- la figure 5B est une vue de détail du dispositif de détection de la figure 5A,
- la figure 6A est une vue en perspective de dessus d'un dispositif de détection compact selon la présente invention également robuste à la force de Coriolis et aux effets de la composante quasi-statique de l'accélération,
- la figure 6B est une vue de détail du dispositif de détection de la figure 6A,
- la figure 7 est une vue de dessus d'un accéléromètre de l'état de la technique,
- les figures 8A à 8F sont des représentations schématiques d'un exemple de procédé de réalisation d'un dispositif de détection selon la présente invention.

## EXPOSÉ DÉTAILLÉ DE MODES DE RÉALISATION PARTICULIERS

Dans la description qui va suivre, les dispositifs de détection décrits sont, à titre d'exemple, des accéléromètres, mais ceux-ci ne sont en aucun cas limitatif, les dispositifs de détection selon la présente invention pouvant permettre la mesure d'autres grandeurs, telles que des forces magnétiques.

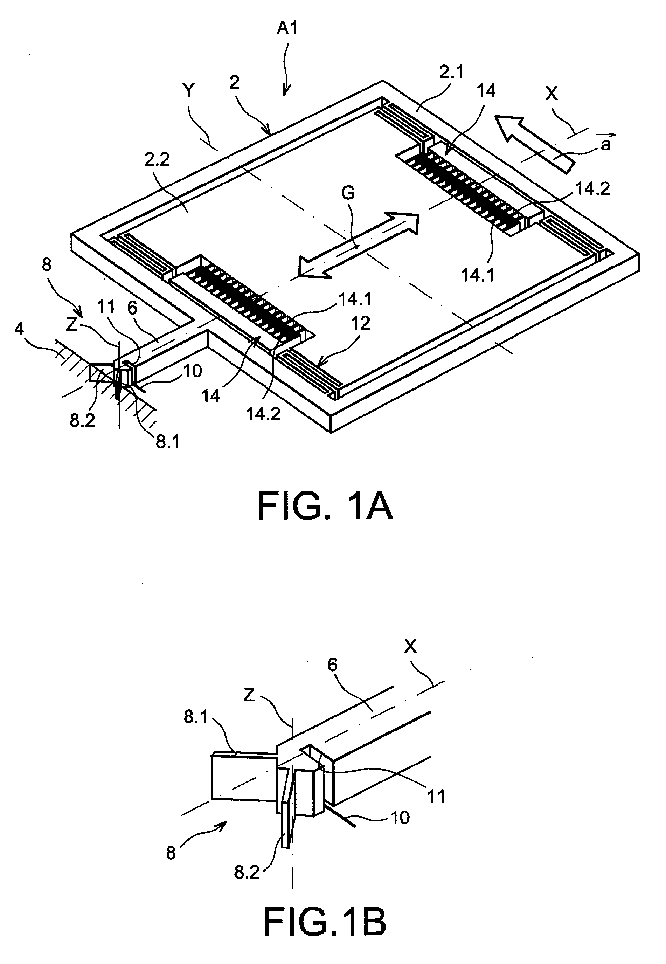

Sur la figure 1A, on peut voir un exemple de réalisation d'un accéléromètre A1 dans le plan, dont l'axe sensible est désigné par Y, i.e. la direction de l'accélération à mesurer, qui est symbolisée par la flèche désignée $\vec{a}$. La direction X désigne la direction d'excitation qui sera décrite par la suite. Dans l'exemple représenté, les directions X et Y sont perpendiculaires et définissent le plan de détection du dispositif de détection.

L'accéléromètre A1 comporte une masse 2 suspendue à un support 4 par un bras 6, dont le centre de gravité est désigné G.

Le bras 6 est connecté au support 4 par l'intermédiaire d'une charnière 8 formant une liaison pivot d'axe Z orthogonal au plan XY.

La masse 2 est destinée à être mise en mouvement par l'accélération et à se déplacer le long de la direction Y autour du pivot Z.

Dans l'exemple représenté, la charnière est formée par deux poutres 8.1 et 8.2 flexibles dans le plan, fixées par une extrémité sur le support 4 en deux point distincts et par une autre extrémité sur le bras 6 en un point commun et définissant l'axe de pivot Z au niveau du point commun de fixation au bras 6. Cette configuration a pour effet avantageux d'obtenir une rotation pure ou quasiment pure de la masse 2 autour de l'axe Z.

Le dispositif de détection comporte également des moyens de détection 10 du déplacement de la masse 2. Dans l'exemple représenté, les moyens de détection 10 sont formés par une jauge piézorésistive dont une extrémité est reliée mécaniquement au bras 6 et l'autre est reliée mécaniquement au support 4.

Dans l'exemple représenté, la jauge piézorésistive 10 est parallèle à la direction Y de l'accélération à mesurer. D'autres configurations peuvent permettre de placer la jauge parallèlement à l'axe X.

L'accéléromètre A1 est peu sensible aux déplacements transverses, i.e. aux déplacements selon une direction orthogonale à la direction Y, car ceux-ci appliquent à la jauge 10, un effort en flexion, auquel la jauge 10 est peu sensible.

De plus, l'accéléromètre est également peu sensible à la température, car en cas de dilatation de du bras, celui-ci applique également un effort de flexion à la jauge 10, auquel elle n'est pas sensible.

De manière particulièrement avantageuse, le bras comporte un évidement latéral 11 de sorte que la jauge se relie au bras sur l'axe passant par l'axe de pivot Z et le centre de gravité G de la masse sismique 2. Cette configuration présente l'avantage que toute ou presque toute l'intensité de contrainte appliquée par le déplacement de la masse sismique 2 participe à la déformation selon l'axe Y de la jauge de contrainte 10. En effet, lorsque l'ancrage de la jauge 10 est décalée par rapport à l'axe passant par la liaison pivot et le centre de gravité G, comme c'est le cas dans le premier mode de réalisation, une partie de la contrainte de déformation exerce sur la jauge un effort de flexion combiné à un effort de compression ou de traction. Or cet effort de flexion ne participe pas ou très peu à la variation de la résistance électrique de la jauge piézorésistive 10.

La masse mobile 2 comporte des première et deuxième parties 2.1, 2.2 aptes à être déplacées l'une par rapport à l'autre.

Dans l'exemple représenté, la première partie 2.1 forme un cadre sur lequel est fixé le bras 6, et la deuxième partie 2.2 est disposée à l'intérieur du cadre 2.1. La deuxième partie 2.2 est suspendue au cadre 2.1 par des moyens de suspension élastiques 12 aptes à se déformer dans la direction X pour permettre le déplacement de la deuxième partie 2.2 le long de la direction X et la ramenant en position repos, centrée dans le cadre 2.1.

Dans l'exemple représenté, le centre de gravité de la deuxième partie 2.2 est confondu avec celui de la masse 2. A des fins de simplicité, le centre de gravité de la deuxième partie sera également désigné G. Cependant la présente invention s'applique à tout système dans le centre de gravité de la masse et celui de la partie mobile ne sont pas confondus.

Dans l'exemple représenté, les moyens élastiques sont formés par quatre ressorts disposés au quatre coins de la partie mobile 2.2 et réalisés directement dans la plaque formant la masse mobile 2.

L'accéléromètre A1 comporte également des moyens 14 pour mettre en mouvement la deuxième partie 2.2 par rapport au cadre 2.1 le long de la direction X. Dans la suite de la description, ces moyens 14 seront désignés par « moyens d'excitation » et la deuxième partie 2.2 sera désignée par « partie mobile 2.2 ». Un jeu est donc prévu entre la partie mobile 2.2 et le cadre 2.1, en particulier entre les extrémités selon l'axe X de la partie mobile 2.2 et les faces en regard du cadre 2.1.

Les moyens d'excitation 14 mettent en mouvement la partie mobile 2.2 à haute fréquence (c'est-à-dire à une fréquence sensiblement plus élevée que la bande passante du capteur, la bande passante étant la fréquence maximum du signal qu'on cherche à mesurer), par exemple de l'ordre de quelques kHz.

Dans l'exemple représenté, les moyens d'excitation 14 sont de type électrostatique. La partie mobile 2.2 comporte à chacune de ses extrémités dans la direction X, des doigts 14.1 en saillie interdigités avec des doigts 14.2 réalisés dans les faces en regard partie ancrée de 14. L'application d'une tension entre la partie mobile et les moyens d'excitation 14 provoque le déplacement de la partie mobile 2.2 par rapport au cadre 2.1 le long de l'axe X. Dans ce mode de réalisation, le cadre 2.1 ne bouge pas selon X, il est en effet retenu par la charnière. Tout autre moyen d'excitation adapté peut être mis en oeuvre, tel que par exemple des moyens d'excitation de type piézoélectrique, magnétique...

Le déplacement de la partie mobile 2.2 dans le cadre 2.1 provoque une modification de la position du centre de gravité de la partie mobile, qui est, dans l'exemple représenté, confondu avec celui G de la masse

L'accéléromètre A1 comporte également des moyens électroniques (non représentés) pour commander les moyens d'excitation 14 d'une part, et pour traiter les variations de résistance de la jauge piézorésistive et convertir ces variations en valeur d'accélération d'autre part. En outre, des moyens (non représentés) pour appliquer une tension continue ou alternative à la jauge, et pour mesurer une variation de courant circulant dans la jauge et de traitement des mesures de variation de courant sont associées à l'accéléromètre A1. La jauge peut aussi être intégrée dans un pont de Wheatstone dont la tension de sortie est proportionnelle à la variation relative de résistance de la jauge.

Nous allons maintenant expliquer le fonctionnement de l'accéléromètre.

L'accéléromètre est fixé sur un objet dont on souhaite mesurer l'accélération par exemple un véhicule automobile, l'accéléromètre étant orienté de sorte que son axe Y soit parallèle à direction de l'accélération à mesurer $\vec{a}$.

Lorsque l'objet est soumis à une accélération $\vec{a}$, l'accéléromètre voit également cette accélération $\vec{a}$, celle-ci provoque alors un déplacement de la masse mobile 2 dans la direction Y, i.e. la masse oscille autour de l'axe de pivot Z.

Dans les accéléromètres de l'état de l'art, la force exercée par l'accélération sur la jauge piézorésistive s'écrit :

$$F = ma\frac{L_g}{d}$$

avec :

- F la force exercée sur la jauge piézorésistive 10 ;
- m la masse de la masse mobile 2,
- a l'accélération
- $L_g$ la distance entre le centre de gravité de la partie mobile qui est désigné G et l'axe de pivot Z,
- d la distance entre l'axe de pivot Z et le point d'ancrage de la jauge piézorésistive sur le bras 6.

La position du centre de gravité de la deuxième partie 2.2 variant le long de l'axe X, la distance $L_g$ varie au cours de la mesure, elle présente donc une composante statique $L_0$ correspondant à la distance entre le centre de gravité G et l'axe de pivot Z au repos et une composante dynamique désignée x qui représente l'amplitude du déplacement de la partie mobile 2.2.

La masse sismique est équivalente alors à deux oscillateurs : le premier dit en excitation comprend la partie mobile 2.2 en mouvement selon X et retenue par les ressorts 12, le deuxième dit en détection comprend la partie 2.1 de la masse mobile 2 en mouvement selon Y et retenue par des ressorts formés par le pivot 8 et la jauge 10.

L'oscillateur dans la direction de détection Y est donc excité par une composante quasi-statique proportionnelle à $L_0$ et une composante à haute fréquence proportionnelle à x et qui est amplifiée par la fonction de transfert de l'oscillateur en détection.

La jauge est soumise à une force quasi-statique $F_s = ma\frac{L_0}{d}$, et à une force dynamique désignée $F^{fexc}$ qui peut s'écrire :

$$F^{f_{exc}} = \frac{m_{2.2}\, a\, \dfrac{x}{d}}{\sqrt{\left(1 - \left(\dfrac{f_{exc}}{f_{det}}\right)^2\right)^2 + \left(\dfrac{f_{exc}}{Q_{det}f_{det}}\right)^2}}$$

avec $m_{2.2}$ la masse de la masse mobile 2.2, $f_{exc}$, la fréquence du déplacement de l'oscillateur en excitation qui est préférentiellement excité à sa fréquence de résonance, $f_{det}$ la fréquence de résonance de l'oscillateur en détection et $Q_{det}$ le facteur de qualité de l'oscillateur en détection.

La force $F^{fexc}$ forme donc un signal à haute fréquence pour les moyens électroniques, ce qui permet de réduire le bruit en 1/f de l'accéléromètre.

En effet, le bruit en 1/f, qui présente une densité spectrale inversement proportionnelle à la fréquence, est dû à une fluctuation de conductivité dans les résistances. Il s'exprime comme suit :

$$V_{1/f}{}^2 = V_b{}^2 \frac{\alpha}{Nf} \quad \text{(en V²/Hz)}$$

avec :

- Vb la tension d'alimentation de la résistance,
- $\alpha$ un coefficient phénoménologique dit coefficient de Hooge,
- N le nombre de porteurs de charge dans la résistance.

Grâce au signal haute fréquence obtenu par la mise en oeuvre d'une partie mobile 2.2 dans la masse mobile 2, l'impact du bruit en 1/f est réduit.

Dans le cas d'un accéléromètre de l'état de l'art, qui exploite un signal quasi-statique, le bruit est intégré sur une plage de fréquence à basse fréquence :

$$V^2_{noise\_quasistat} = \int_{f_0}^{BP} V_b{}^2 \frac{\alpha}{Nf} df$$

avec $f_0$ une fréquence minimum sensiblement inférieure à 1Hz et BP la bande passante du capteur (fréquence maximum de l'accélération qu'on cherche à mesurer).

Dans le cas d'un accéléromètre selon la présente invention, le signal est intégré à haute fréquence entre la fréquence $f_{exc}$ et $f_{exc}$+BP:

$$V^2_{noise\_dynamique} = \int_{fexc}^{fexc+BP} V_b{}^2 \frac{\alpha}{Nf} df$$

On a alors Clairement $V^2_{noise\_quasistat} \gg V^2_{noise\_dynamique}$

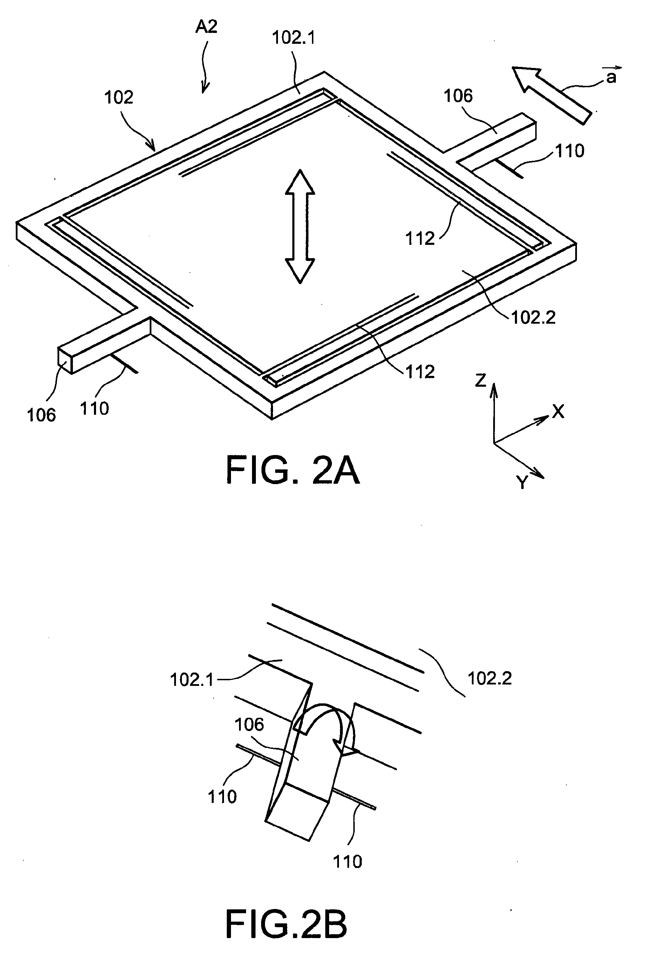

Sur les figures 2A et 2B, on peut voir un autre exemple de réalisation d'un accéléromètre A2 dans le plan.

Dans cet exemple de réalisation, la masse mobile est suspendue au moyen de deux bras de torsion 106 alignés suivant l'axe X et donc perpendiculaires à l'axe sensible Y.

Par ailleurs, la partie mobile 102.2 est mobile selon la direction Z, i.e. hors du plan et non le long de la direction X. Pour cela, les moyens élastiques de suspension 112 ont été modifiés par rapport à ceux 12 de l'exemple de la figure 1A, de sorte à autoriser les déplacements hors plan et à exercer une force de rappel sur la partie mobile 102.2 vers la position repos. Les moyens élastiques de suspension 112 sont formés par exemple par quatre poutres reliées chacune par une extrémité à une face intérieure du cadre 102.1 et par un autre à la masse mobile 102.2 et travaillant en flexion. Dans l'exemple représenté, le cadre 102.1 et la partie mobile 102.2 sont d'un seul tenant et les poutres sont gravées dans la partie mobile 102.2. Dans la partie mobile 102.2 chaque poutre est perpendiculaire aux poutres directement adjacentes.

Comme on peut le voir sur la figure 2A, les jauges piézorésistives 110 sont fixées par une extrémité à un ancrage et par une autre extrémité aux bras de torsion 106 perpendiculaires à leur axe et dans un plan ne contenant pas leur axe de torsion de sorte à être effectivement déformées, lorsque la masse mobile 102 est mise en mouvement et provoque la torsion des poutres 106 en présence d'une force d'accélération selon Y. Deux jauges 110 sont fixées sur chaque bras de torsion 106 sur deux faces opposées, déformées toutes deux par la rotation de la masse mobile 102.1.

Les deux jauges 110 sont avantageusement montées en différentiel, ce qui permet avantageusement de s'affranchir de l'effet des variations de température.

Le montage de deux jauges en différentiel peut être mis en oeuvre dans tous les exemples de réalisation.

Comme pour l'exemple de la figure 1A, des moyens d'excitation de la partie mobile 102.2 le long de l'axe Z (non représentés), par rapport au cadre 102.1, sont prévus.

Lorsque la partie mobile 102.2 de la masse mobile 102 est au repos, le centre de gravité de la partie mobile 102.2 et donc celui de la masse mobile 102, dans l'exemple représenté, se situe sur l'axe de torsion et donc ne déforme pas les bras 106 en torsion. Lorsque la partie mobile 102.1 est mise en mouvement le long de l'axe Z par les moyens d'excitation, le centre de gravité G se décale vers le haut ou vers le bas dans la représentation de la figure 2A, et la force générée par une accélération provoque une torsion des bras de torsion 106 et donc une contrainte dans les jauges.

Les jauges 110 sont alors soumises à un signal quasi-statique et à un signal dynamique à haute fréquence, ce qui permet de réduire l'impact du bruit en 1/f. En réduisant suffisamment son impact, celui-ci peut alors ne plus limiter la résolution de l'accéléromètre.

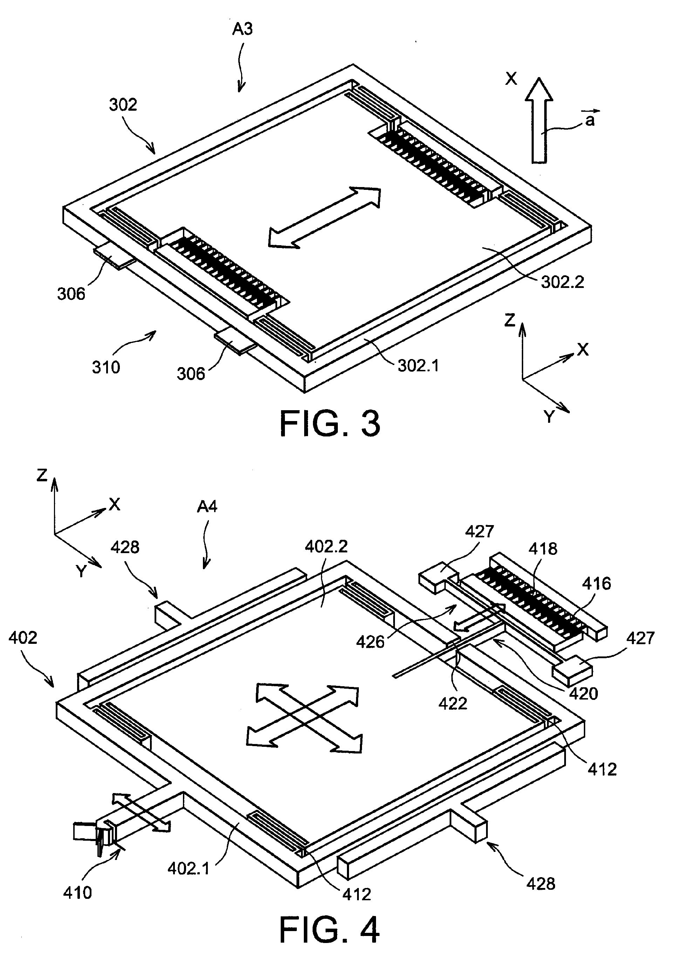

Sur la figure 3, on peut voir un exemple de réalisation d'un accéléromètre hors-plan A3 permettant de mesurer l'accélération d'axe Z, l'axe sensible de l'accéléromètre A3 est donc l'axe Z perpendiculaire au plan de la masse mobile 302.

La structure de l'accéléromètre A3 est très proche de celle de l'accéléromètre A1, elle diffère de celle-ci en ce que la masse mobile est suspendue au support par l'intermédiaire de charnières 306 d'axe Y.

Une jauge 310 est prévue et son ancrage à la masse 302 est décalé selon Z par rapport à l'axe du pivot Y constitué par les charnières 306.

La partie mobile 302.2 est excitée dans le plan.

Le fonctionnement est similaire à celui de l'accéléromètre A1 et ne sera pas répété.

Sur la figure 4, on peut voir un autre exemple de réalisation d'un accéléromètre A4.

L'accéléromètre A4 est un accéléromètre dans le plan de structure proche de celle de l'accéléromètre A1. L'accéléromètre A4 se distingue de l'accéléromètre A1 en ce que les moyens d'excitation de la partie mobile ne mettent plus directement en mouvement la masse 402.2, mais mettent en mouvement une partie, dite masse sismique intermédiaire, distincte de la masse 402.2 et qui ne peut se déplacer que selon la direction d'excitation X, ce mouvement d'excitation selon X étant transmis à la masse 402.2 par l'intermédiaire de la poutre 420. Ceci permet de découpler mécaniquement l'excitation et la détection. Les moyens d'excitation ne risquent alors plus de perturber le mouvement du cadre 402 selon la direction de détection.

Pour cela, les moyens d'excitation comportent deux peignes interdigités 416, 418, l'un des peignes 416 est fixe sur le support, l'autre peigne 418 est solidaire de la partie mobile 402.2 et est relié à celle-ci par un bras de liaison 420 d'axe X. Le cadre 402.1 comporte une ouverture 422 pour le passage du bras de liaison 420.

La partie mobile 402.2 est suspendue dans le cadre 402.1 par des moyens 412.

Par ailleurs, des moyens de rappel sont prévus entre la masse sismique intermédiaire et le support, formés par exemple par deux poutres 426 ancrées par une extrémité sur des plots 427 du support et fixées par une autre extrémité sur une face latérale de la masse sismique intermédiaire . Les moyens de rappel ont pour caractéristique d'être déformables selon la direction d'excitation X et rigides selon les autres directions.

De manière avantageuse, on peut accorder les fréquences de résonance $f_{exc}$ et $f_{det}$ des oscillateurs en excitation et en détection pour maximiser la sensibilité de l'accéléromètre. Dans ce cas, la force à haute fréquence subie par les jauges 10 s'écrit :

$$ F^{f_{exc}} = m_{2.2} a \frac{x}{d} Q_{\mathrm{det}} $$

Dans l'exemple représenté, l'accéléromètre A4 comporte également des électrodes 428, qui peuvent être des électrodes de contre-réaction ou des électrodes de trimming, disposées de part et d'autre de la masse mobile par rapport à l'axe X.

Dans le cas d'électrodes de trimming, elles permettent d'introduire une raideur négative abaissant la fréquence propre de l'oscillateur en détection, la raideur ainsi introduite est proportionnelle au carré de la tension statique appliquée sur lesdites électrodes.

La structure peut être asservie en détection dans le cas où les électrodes 428 sont des électrodes de contre-réaction. Par l'application d'une tension alternative, on génère une force dite de contre-réaction, qui a une valeur opposée à la force d'accélération que subit la masse 402 et ainsi, la masse 402 est asservie dans sa position d'équilibre. Le fonctionnement asservi du capteur permet d'améliorer la linéarité de la mesure et le domaine linéaire du capteur ne dépend plus de la linéarité des moyens de mesure, mais de la force maximale pouvant être générée par les électrodes de contre-réaction, qui dépend de la tension maximale pouvant être appliquée sur les électrodes et des dimensions des électrodes.

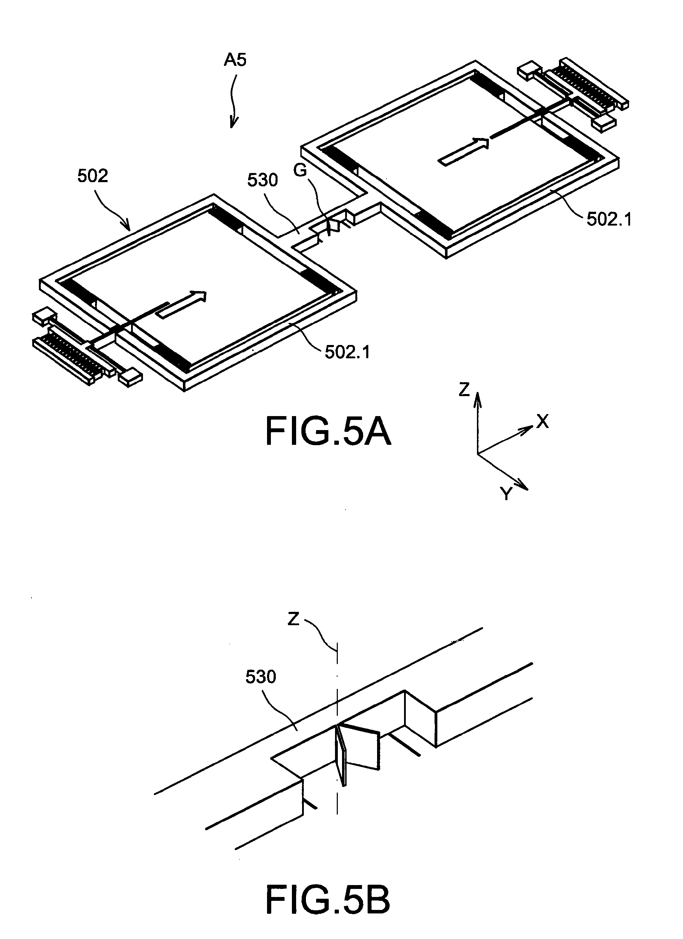

Sur les figures 5A et 5B, on peut voir un autre exemple d'accéléromètre A5 peu influencé par la force de Coriolis et par la composante quasi-statique de l'accélération.

L'accéléromètre A5 comporte deux masses mobiles 502. Dans l'exemple représenté, l'accéléromètre A5 est formé de deux structures proches de celle de l'accéléromètre A4, les deux masses 502 étant reliées l'une à l'autre rigidement.

Dans l'exemple représenté, les cadres 502.1 sont reliés par un bras de liaison sur lequel est réalisée la charnière d'axe Z, qui est particulièrement visible sur la figure 5B. L'accéléromètre comporte également des jauges piézorésistives 510 fixées par une extrémité à l'arbre de liaison 530 de part et d'autre de l'axe Z.

Comme on peut le voir, l'axe de pivot Z se situe proche du centre de gravité G de la structure. Par conséquent, l'accéléromètre A5 présente une structure équilibrée au repos, qui le rend peu sensible à la composante quasi-statique de l'accélération. En outre, les deux oscillateurs en excitation sont actionnés en phase, et, dans le cas où le capteur est soumis à une rotation, les forces de Coriolis $\vec{F}_{Coriolis} = 2m\vec{v}\times\vec{\Omega}$ qui résultent sur chaque masse se compensent. Cette structure permet avantageusement de supprimer la composante quasi-statique de l'accélération, et donc de simplifier les moyens électroniques de traitement. En effet, dans le cas des accéléromètres A1 à A4, les jauges, et plus généralement les moyens de détection, subissent toujours une force quasi-statique due à la contribution quasi-statique de la force due à l'accélération. Cette contribution est à une fréquence différente du signal haute fréquence obtenu grâce à la présente invention. Dans le cas de réponse non parfaitement linéaire des moyens de détection, la réponse à haute fréquence peut être influencée par la contrainte exercée sur la jauge à basse fréquence et rendre les mesures moins fiables. Grâce à la structure équilibrée de l'accéléromètre A5, cette influence est supprimée.

On peut prévoir de réaliser des structures d'accéléromètres équilibrées comportant une seule partie mobile d'excitation et une seule masse de détection.

Des systèmes de contre-réaction, tels que les électrodes précédemment citées, et de compensation du biais en quadrature peuvent être prévus. Ceux-ci sont connus de l'homme du métier et ne seront pas décrits en détail. Il est à noter que dans les dispositifs de détection selon la présente invention, la compensation en quadrature se fait par l'application d'une tension continue et d'une tension alternative dont la fréquence est double de la fréquence d'excitation au lieu d'appliquer uniquement une tension continue comme dans les gyroscopes de l'état de l'art.

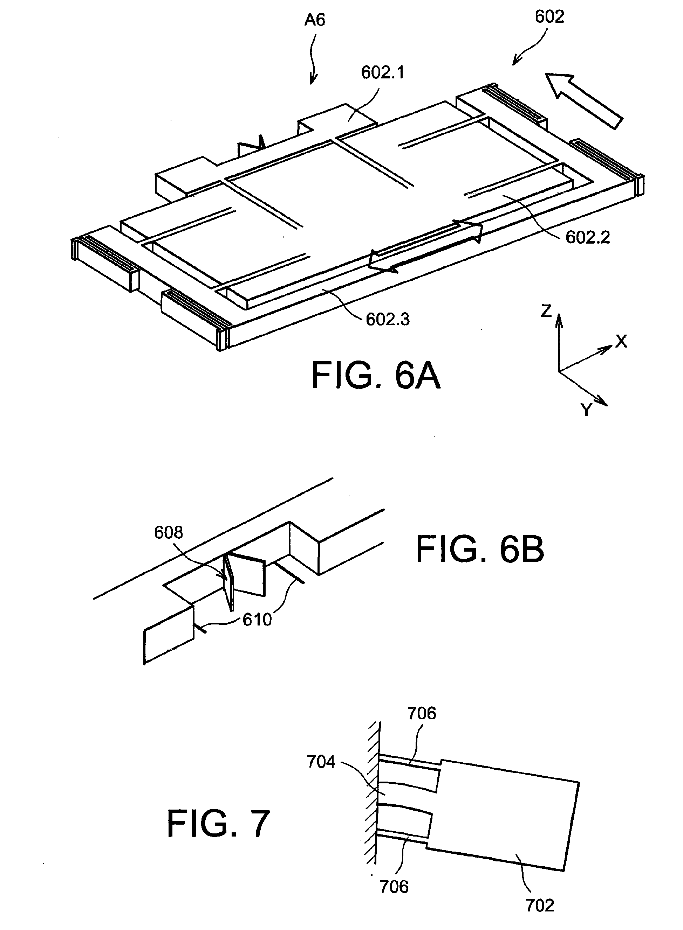

Sur les figures 6A et 6B, on peut voir un autre exemple de réalisation d'un accéléromètre A6 offrant également une structure équilibrée, et donc présentant une certaine robustesse à la force de Coriolis et aux effets de la composante quasi-statique de l'accélération.

L'accéléromètre A6 comporte une masse mobile 602 de forme sensiblement parallélépipédique rectangle. La masse 602 est composée d'une première partie 602.1 articulée sur le support via une charnière 608 d'axe Z, d'une partie mobile 602.2 et d'une partie intermédiaire 602.3 formant une masse sismique intermédiaire.

La partie intermédiaire 602.3 a la forme de U suspendue par des ressorts 612 au niveau des deux branches du U, et entourant sur trois côtés la partie mobile 602.2.

La partie 602.1 n'est autorisée à bouger qu'en rotation autour de la charnière 608. La partie 602.3 ne bouge qu'en excitation selon X, de manière équivalente à la masse intermédiaire 418. Elle entraine avec elle la deuxième partie 602.2 qui bouge à la fois en excitation (selon X) et en détection (rotation autour de Z).

Les connexions entre la partie mobile 602.2 et la première partie 602.1, et entre la partie intermédiaire 602.3 et la partie mobile 602.2 sont formés par des poutres, les poutres étant par exemple gravées directement dans la partie mobile.

Les jauges piézorésistive 610 sont fixées de part et d'autre de la charnière comme cela est visible sur la figure 6B.

Des moyens d'excitation (non représentés) de la partie mobile dans la direction X sont également prévus.

L'accéléromètre A6 présente une plus grande compacité que la structure A5 par exemple.

La structure, outre sa robustesse à la force de Coriolis et aux effets de la composante quasi-statique de l'accélération, permet de minimiser le bruit brownien grâce à la réduction du bras de levier entre la masse et l'axe de pivot.

A titre d'exemple, nous allons comparer les bruits et les performances d'un accéléromètre de l'état de la technique et ceux d'accéléromètres selon la présente invention.

L'accéléromètre de l'état de la technique est par exemple celui représenté sur la figure 7, comportant une masse mobile monolithique 702 suspendue par une poutre flexible 704, des moyens d'excitation de la masse agissant sur la poutre 704 et des moyens de détection piézorésistifs 706.

La masse sensible présente les dimensions suivants 300 $\mu$m x200 $\mu$m x 10 $\mu$m. On fait par ailleurs les hypothèses suivantes :

- bande passante de 10Hz,
- coefficient de Hooge $\alpha=10^{-6}$,
- dopage $10^{19}$ impuretés/cm$^{-3}$,
- Vb = 3V,
- contrainte maximum sur la jauge (définit la pleine échelle) 100MPa.
- une fréquence de résonance de 5kH, et
- un facteur de qualité de 50000 pour l'accéléromètre résonant.

| | Accéléromètre de l'état de la technique (figure 7) | Accéléromètre selon l'invention ; fréquences accordées | Accéléromètre selon l'invention; fréquences non accordées |
|---|---|---|---|
| Bruit Brownien ($V^2$/Hz) | $8.55.10^{-14}$ | $1.68.10^{-13}$ | $3.44.10^{-17}$ |
| Bruit Johnson ($V^2$/Hz) | $1.59.10^{-16}$ | $2.65.10^{-16}$ | $2.10^{-16}$ |
| Bruit en 1/f ($V^2$/Hz) | $6.91.10^{-13}$ | $7.2.10^{-17}$ | $9.6.10^{-17}$ |
| Bruit électronique ($V^2$/Hz) | $10^{-16}$ | $10^{-16}$ | $10^{-16}$ |
| Résolution ($\mu$g/$\sqrt{Hz}$) | 46 | 11 | 42 |
| Domaine linéaire (g) | 11 | 2.8 | 214 |
| Résolution/domaine linéaire pour une bande passante de 10Hz | $4.2.10^{-5}$ | $3.9.10^{-5}$ | $2.10^{-6}$ |

On constate une diminution importante du bruit en 1/f qui n'est alors plus prédominant dans le cas d'un accéléromètre selon la présente invention avec des fréquences accordées, et la résolution est divisée par 4. Le bruit brownien devient alors prédominant. Dans le cas d'un accéléromètre selon la présente invention avec les fréquences non accordées, on a une résolution quasiment identique à l'accéléromètre de l'état de la technique. En revanche, on obtient un gain d'un facteur 20 sur la pleine échelle.

Pour diminuer le bruit brownien, comme indiqué ci-dessus, on peut par exemple réduire le bras de levier.

Le capteur peut utiliser d'autres moyens de détection que les jauges piézorésistives, comme des moyens capacitifs, piézoélectriques, magnétiques... quand bien même le bruit en 1/f n'est pas le bruit dominant pour ces moyens de détection.

De manière préférentielle, les accéléromètres, et plus généralement les capteurs de force sont mis en oeuvre sous vide.

Avantageusement, un ou plusieurs accéléromètres peut ou peuvent être associé(s) à un ou des gyroscope(s), notamment pour effectuer la reconstitution de mouvement, les gyroscopes requérant un fonctionnement sous vide. Par ailleurs, les moyens électroniques associés à l'accéléromètre et ceux associés à un gyroscope sont relativement proches, on peut donc envisager d'utiliser les mêmes moyens électroniques qui commanderaient de manière alternée un ou plusieurs gyroscopes et un ou plusieurs accéléromètres.

De manière avantageuse, les deux parties de la masse mobile, les moyens de suspension de la partie mobile, de la masse sur le support, les moyens de détection, type jauge piézorésistives, sont réalisés d'un seul tenant par dépôt de couches et gravures.

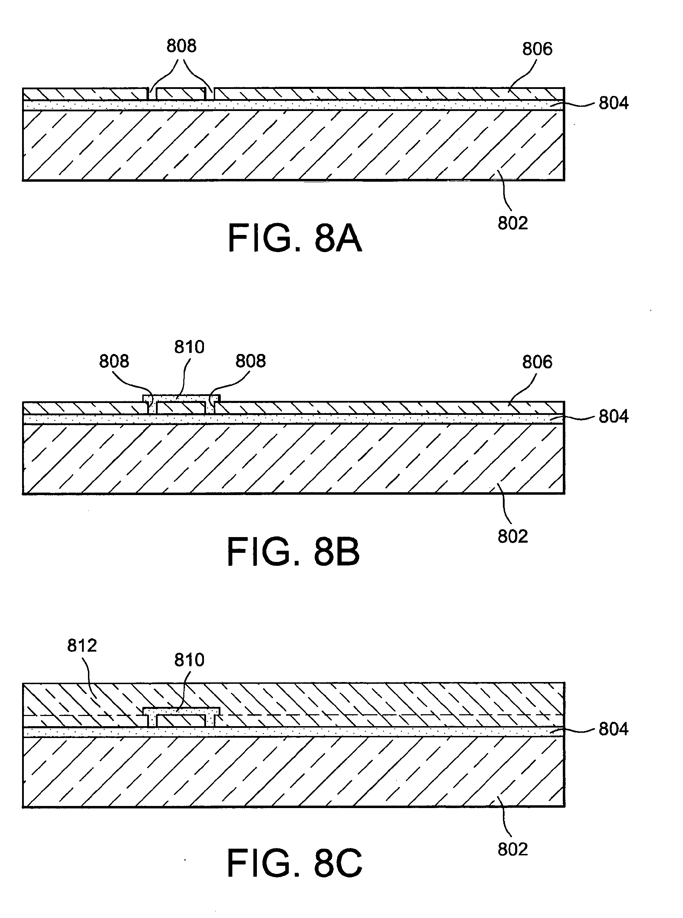

Nous allons maintenant décrire un tel procédé de réalisation d'un accéléromètre, dont on peut voir représentées schématiquement différentes étapes sur les figures 8A à 8F.

On utilise, par exemple une structure SOI (Silicium on insulator) comportant un substrat 802, une couche d'oxyde enterré BOX (Buried oxide) 804, et une couche de silicium 806. La couche de silicium 806 a par exemple une épaisseur de l'ordre de 200 nm. D'une manière générale, la couche 806 peut être du Si, SiGe ou Ge poly ou mono-cristallin.

On réalise ensuite une structuration de la couche de silicium 806, par exemple par photolithographie et gravure avec arrêt sur la couche d'oxyde 806, ce qui permet de définir la jauge piézorésistive, comme on peut le voir sur la figure 8A.

Lors d'une étape suivante représentée sur la figure 8B, on effectue un dépôt d'une couche d'oxyde 810 sur la couche silicium 806 pour combler les zones 808 préalablement gravées, on effectue ensuite une gravure de la couche d'oxyde 810 pour ne laisser subsister qu'une portion d'oxyde déposé sur la couche de silicium 806 et reliant l'oxyde remplissant les tranchées. La gravure peut être réalisée par gravure sèche avec arrêt sur Si ou par gravure humide, par exemple en utilisant une solution à base d'acide sulfurique.

Lors d'une étape suivante représentée sur la figure 8C, on forme un dépôt d'une couche de silicium 812. La couche 812 est obtenue par exemple, par croissance épitaxiale, et présente une épaisseur typique de 1 à 50$\mu$m, par exemple 10$\mu$m. Plus généralement, la couche 812 peut être constituée de Si, SiGe, Ge, poly ou mono-cristallin ou d'un matériau métallique ; le dépôt peut être réalisé par épitaxie ou par des méthodes de type dépôt physique/chimique en phase vapeur (PVD/CVD : Physical/Chemical Vapor Deposition).

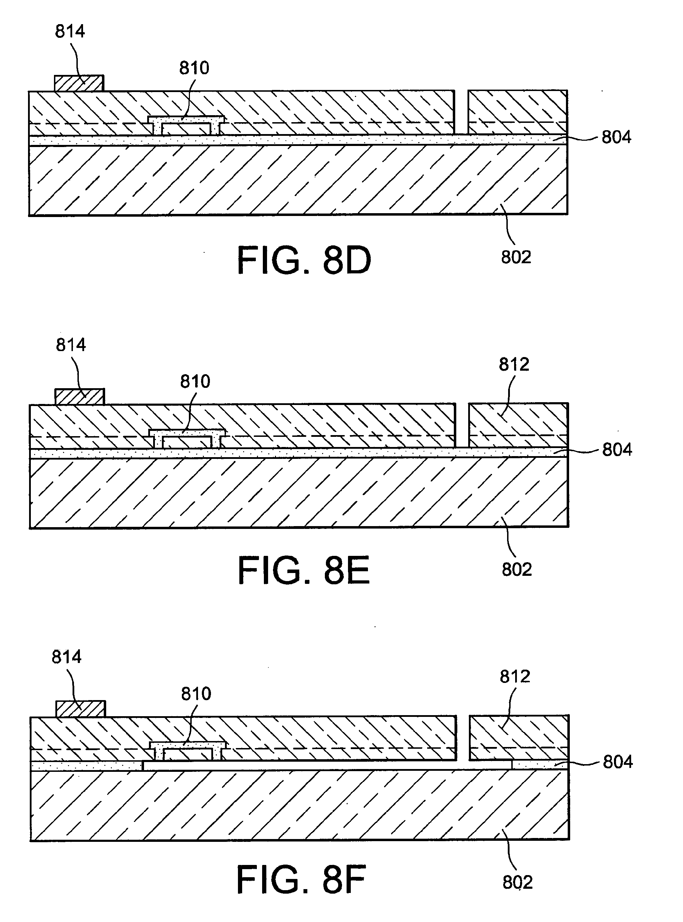

Lors d'une étape suivante représentée sur la figure 8D, on réalise des contacts électriques 814. Pour cela, on effectue un dépôt d'une couche métallique (AlSi ou Au par exemple), on distingue les zones à supprimer et à conserver par photolithographie. On grave ensuite par gravure sèche avec arrêt sur Si ou par gravure humide sélective par rapport au Si la couche métallique pour ne conserver que les contacts 814.

Lors d'une étape suivante représentée sur la figure 8E, on structure les couches de silicium 806 et 812 pour définir la masse mobile et les pivots, par exemple par photolithographie et gravure profonde avec arrêt sur la couche d'oxyde 804.

Lors d'une étape suivante représentée sur la figure 8F, on libère la masse mobile, la jauge et les pivots par exemple par gravure humide de l'oxyde 804, par exemple au moyen d'acide fluorhydrique (HF) liquide et/ou vapeur. Il s'agit d'une gravure au temps. L'acide fluorhydrique est laissé au contact de la couche d'oxyde le temps nécessaire pour libérer masse mobile, la jauge et les pivots tout en laissant la couche d'oxyde entre le substrat et les parties fixes.

## Revendications

1. Dispositif de détection microélectromécanique ou nanoélectromécanique d'une force selon une direction donnée, comportant un support (4) et au moins une masse sismique (2, 102, 302 , 402, 502, 602) apte à se déplacer sous l'effet de la force à mesurer dans la direction de ladite force, et des moyens de détection (10, 110, 310, 410, 510, 610) du déplacement de ladite masse sismique, ladite masse sismique étant articulée par rapport au support par au moins une liaison pivot, et un actionneur apte à faire varier à haute fréquence la distance entre l'axe (Z) de la liaison pivot et le centre de gravité (G) de l'exercice de la force sur ladite masse sismique, ledit dispositif étant **caractérisé en ce que** ladite masse sismique (2, 102, 302 , 402, 502, 602) comporte au moins des première (2.1, 102.1, 302.1, 402.1, 502.1, 602.1) et deuxième (2.2, 102.2, 302.2, 402.2, 502.2, 602.2) parties mobiles l'une par rapport à l'autre, et dans lequel l'actionneur (14, 414) est apte à déplacer la deuxième partie (2.2, 102.2, 302.2, 402.2, 502.2, 602.2) de la masse sismique par rapport à la première partie (2.1, 102.1, 302.1, 402.1, 502.1, 602.1) de la masse sismique dans une direction différente de celle de la force à mesurer, dite axe d'excitation.

2. Dispositif de détection selon la revendication 1, dans lequel la fréquence d'excitation de l'actionneur est de l'ordre de quelques kHz.

3. Dispositif de détection selon la revendication 1 ou 2, dans lequel l'actionneur (14) est disposé entre la première (2.1) et la deuxième (2.2) parties et s'exerce sur la deuxième partie.

4. Dispositif de détection selon l'une des revendications 1 à 3, dans lequel l'actionneur (414) est disposé entre le support et la deuxième partie (402.2) et s'exerce sur la deuxième partie par l'intermédiaire d'une masse sismique intermédiaire (418) apte à se déplacer uniquement selon l'axe d'excitation.

5. Dispositif de détection selon l'une des revendications 1 à 4, dans lequel l'actionneur est de type électrostatique, piézoélectrique ou magnétique.

6. Dispositif de détection selon l'une des revendications 1 à 5, dans lequel les moyens de détection sont de type capacitif, piézoélectrique, magnétique, piézorésistif, fréquentiel.

7. Dispositif de détection selon la revendication 6, dans lequel les moyens de détection (10) comportent au moins une jauge piézorésistive, et avantageusement deux jauges piézorésistives disposées de part et d'autre de l'axe (Z) de la liaison pivot.

8. Dispositif de détection selon la revendication 7, dans lequel la deuxième partie (2.2) de la masse sismique (2) est apte à se déplacer dans un plan de la masse sismique (2), les moyens de suspension (12) étant formés par au moins un ressort se déformant dans le plan.

9. Dispositif de détection selon l'une des revendications 1 à 7, dans lequel la deuxième partie (102.2) de la masse sismique (102) a un mouvement hors du plan de la masse sismique (102), les moyens de suspension (112) étant formés par au moins un ressort se déformant hors du plan.

10. Dispositif de détection selon l'une des revendications 1 à 9, dans lequel la première partie (2.1) forme un cadre à l'intérieur duquel est suspendue la deuxième partie (2.2).

11. Dispositif de détection selon l'une des revendications 1 à 10, comportant deux masses sismiques (502) comprenant chacune une première et une deuxième partie reliées entre elles et mobiles l'une par rapport à l'autre, les premières parties étant reliées rigidement par un bras (530), la liaison pivot étant réalisée sur le bras (530), et les moyens de détection (510) détectant le déplacement dudit bras, les deux deuxièmes parties mobiles se déplaçant en phase entre-elles.

12. Dispositif de détection selon l'une des revendications 1 à 10, comportant une masse sismique présentant au moins des première et deuxième parties mobiles l'une par rapport à l'autre, la liaison pivot étant réalisé sur la première partie (402.1), l'actionneur (414) étant disposé entre le support et la deuxième partie (402-2) et s'exerçant sur celle-ci par l'intermédiaire d'une masse sismique intermédiaire (418) apte à se déplacer uniquement selon l'axe d'excitation, lesdites deux parties étant disposées l'une par rapport à l'autre de sorte que l'axe coupant l'axe (Z) de la liaison pivot et passant par le centre de gravité (G) de la masse, en l'absence d'excitation, soit perpendiculaire à la direction de la force à détecter

13. Dispositif de détection selon l'une des revendications 1 à 12, dans lequel la au moins une masse sismique (2) est suspendue par une poutre, l'axe (Z) de la liaison pivot étant sensiblement orthogonal au plan de dispositif.

14. Dispositif de détection selon la revendication 13 en combinaison avec la revendication 6, dans lequel la liaison mécanique entre la ou les jauge (s) piézorésistive(s) (10) et la masse sismique (2) se situe sur ou au plus près du plan contenant le centre de gravité (G) et l'axe de la liaison pivot (Z).

15. Dispositif de mesure selon l'une des revendications 1 à 12, dans lequel la masse sismique (102) est suspendue par un arbre de torsion dont l'axe est contenu dans le plan.

16. Dispositif de détection selon l'une des revendications 1 à 15, comportant des électrodes de contre-réaction (428) et/ou des électrodes d'ajustement de fréquence de résonance (428).

17. Accéléromètre formé par un dispositif de mesure de force selon l'une des revendications 1 à 16.

18. Accéléromètre selon la revendication 17 comprenant des électrodes de compensation de biais en quadrature sur lesquelles on applique une tension continue et une tension alternative à une fréquence double de la fréquence d'excitation.

19. Accéléromètre selon la revendication 17 ou 18, étant mis en oeuvre sous vide.

**Patentansprüche**

1. Mikroelektromechanische oder nanoelektromechanische Vorrichtung zur Detektion einer Kraft entlang einer gegebenen Richtung, die einen Träger (4) und mindestens eine seismische Masse (2, 102, 302, 402, 502, 602), die geeignet ist, sich unter der Wirkung der zu messenden Kraft in die Richtung der Kraft zu verlagern, und Mittel (10, 110, 310, 410, 510, 610) zur Detektion der Verlagerung der seismischen Masse, wobei die seismische Masse in Bezug zum Träger über mindestens eine Schwenkverbindung gelenkig ist, und ein Stellglied umfasst, das geeignet ist, den Abstand zwischen der Achse (Z) der Schwenkverbindung und dem Schwerpunkt (G) der Ausübung der Kraft auf die seismische Masse mit hoher Frequenz zu variieren, wobei die Vorrichtung **dadurch gekennzeichnet ist, dass** die seismische Masse (2, 102, 302, 402, 502, 602) mindestens erste (2.1, 102.1, 302.1, 402.1, 502.1, 602.1) und zweite (2.2, 102.2, 302.2, 402.2, 502.2, 602.2) Teile umfasst, die zueinander beweglich sind, und dass das Stellglied (14, 414) geeignet ist, den zweiten Teil (2.2, 102.2, 302.2, 402.2, 502.2, 602.2) der seismischen Masse in Bezug zum ersten Teil (2.1, 102.1, 302.1, 402.1, 502.1, 602.1) der seismischen Masse in eine Richtung zu verlagern, die sich von derjenigen der zu messenden Kraft unterscheidet, die Erregungsachse genannt wird.

2. Detektionsvorrichtung nach Anspruch 1, wobei die Erregungsfrequenz des Stellglieds in der Größenordnung von einigen kHz liegt.

3. Detektionsvorrichtung nach Anspruch 1 oder 2, wobei das Stellglied (14) zwischen dem ersten (2.1) und dem zweiten (2.2) Teil angeordnet ist, und auf den zweiten Teil einwirkt.

4. Detektionsvorrichtung nach einem der Ansprüche 1 bis 3, wobei das Stellglied (414) zwischen dem Träger und dem zweiten Teil (402.2) angeordnet ist, und über eine seismische Zwischenmasse (418), die geeignet ist, sich einzig entlang der Erregungsachse zu verlagern, auf den zweiten Teil einwirkt.

5. Detektionsvorrichtung nach einem der Ansprüche 1 bis 4, wobei das Stellglied vom elektrostatischen, piezoelektrischen oder magnetischen Typ ist.

6. Detektionsvorrichtung nach einem der Ansprüche 1 bis 5, wobei die Detektionsmittel vom kapazitiven, piezoelektrischen, magnetischen, piezoresistiven, frequenziellen Typ sind.

7. Detektionsvorrichtung nach Anspruch 6, wobei die Detektionsmittel (10) mindestens einen piezoresistiven Messkörper und vorzugsweise zwei piezoresistive Messkörper umfassen, die auf beiden Seiten der Achse (Z) der Schwenkverbindung angeordnet sind.

8. Detektionsvorrichtung nach Anspruch 7, wobei der zweite Teil (2.2) der seismischen Masse (2) geeignet ist, sich in einer Ebene der seismischen Masse (2) zu verlagern, wobei die Aufhängungsmittel (12) durch mindestens eine Feder gebildet sind, die sich in der Ebene verformt.

9. Detektionsvorrichtung nach einem der Ansprüche 1 bis 7, wobei der zweite Teil (102.2) der seismischen Masse (102) eine Bewegung außerhalb der Ebene der seismischen Masse (102) aufweist, wobei die Aufhängungsmittel (112) durch mindestens eine Feder gebildet sind, die sich außerhalb der Ebene verformt.

10. Detektionsvorrichtung nach einem der Ansprüche 1 bis 9, wobei der erste Teil (2.1) einen Rahmen bildet, in dessen Innenraum der zweite Teil (2.2) aufgehängt ist.

11. Detektionsvorrichtung nach einem der Ansprüche 1 bis 10, die zwei seismische Massen (502) umfasst, die jeweils einen ersten und einen zweiten Teil umfassen, die miteinander verbunden und zueinander beweglich sind, wobei die ersten Teile starr durch einen Arm (530) verbunden sind, wobei die Schwenkverbindung auf dem Arm (530) ausgeführt ist und die Detektionsmittel (510) die Verlagerung des Armes detektieren, wobei die zwei zweiten beweglichen Teile sich phasengleich zueinander verlagern.

12. Detektionsvorrichtung nach einem der Ansprüche 1 bis 10, die eine seismische Masse umfasst, die mindestens erste und zweite Teile umfasst, die zueinander beweglich sind, wobei die Schwenkverbindung auf dem ersten Teil (402.1) ausgeführt ist, das Stellglied (414) zwischen dem Träger und dem zweiten Teil (402.2) angeordnet ist und darauf über eine seismische Zwischenmasse (418) einwirkt, die geeignet ist, sich einzig entlang der Erregungsachse zu verlagern, wobei die zwei Teile derart in Bezug zueinander angeordnet sind, dass die Achse, die die Achse (Z) der Schwenkverbindung schneidet und bei nicht vorhandener Erregung durch den Schwerpunkt (G) der Masse verläuft, senkrecht zur Richtung der zu detektierenden Kraft ist.

13. Detektionsvorrichtung nach einem der Ansprüche 1 bis 12, wobei die mindestens eine seismische Masse (2) über einen Strahl aufgehängt ist, wobei die Achse (Z) der Schwenkverbindung im Wesentlichen orthogonal zur Ebene der Vorrichtung ist.

14. Detektionsvorrichtung nach Anspruch 13 in Kombination mit Anspruch 6, wobei die mechanische Verbindung zwischen dem oder den piezoresistiven Messkörper/n (10) und der seismischen Masse (2) sich am Nächsten an der Ebene befindet, die den Schwerpunkt (G) und die Achse der Schwenkverbindung (Z) enthält.

15. Messvorrichtung nach einem der Ansprüche 1 bis 12, wobei die seismische Masse (102) über eine Torsionswelle aufgehängt ist, deren Achse in der Ebene enthalten ist.

16. Detektionsvorrichtung nach einem der Ansprüche 1 bis 15, die Rückkopplungselektroden (428) und/oder Resonanzfrequenz-Anpassungselektroden (428) umfasst.

17. Beschleunigungsmesser, der aus einer Kraftmessungsvorrichtung nach einem der Ansprüche 1 bis 16 gebildet ist.

18. Beschleunigungsmesser nach Anspruch 17, der Quadraturbias-Kompensationselektroden umfasst, an die eine Gleichspannung und eine Wechselspannung mit einer Frequenz angelegt werden, die dem Doppelten der Erregungsfrequenz entspricht.

**19.** Beschleunigungsmesser nach Anspruch 17 oder 18, der im Vakuum eingesetzt wird.

**Claims**

**1.** A microelectromechanical or nanoelectromechanical device for detecting a force following a given direction, comprising a support (4) and at least one seismic mass (2, 102, 302, 402, 502, 602) capable of moving under the effect of the force to be measured in the direction of said force, and means (10, 110, 310, 410, 510, 610) for detecting the movement of said seismic mass, said seismic mass being articulated relative to the support by at least one pivot link, and an actuator capable of making the distance between the axis (Z) of the pivot link and the center of gravity (G) of the exertion of the force on said seismic mass vary at high frequency, said device being **characterized in that** said seismic mass (2, 102, 302 , 402, 502, 602) comprises at least first part (2.1, 102.1, 302.1, 402.1, 502.1, 602.1) and second part (2.2, 102.2, 302.2, 402.2, 502.2, 602.2) able to move relative to each other, and wherein the actuator (14, 414) is capable of moving the second part (2.2, 102.2, 302.2, 402.2, 502.2, 602.2) of the seismic mass relative to the first part (2.1, 102.1, 302.1, 402.1, 502.1, 602.1) of the seismic mass in a direction different from that of the force to be measured, called excitation axis.

**2.** The detection device according to claim 1, wherein the excitation frequency of the actuator is in the vicinity of several kHz.

**3.** The detection device according to claim 1 or 2, wherein the actuator (14) is arranged between the first (2.1) and second (2.2) parts and is exerted on the second part.

**4.** The detection device according to one of claims 1 to 3, wherein the actuator (414) is arranged between the support and the second part (402.2) and is exerted on the second part via an intermediate seismic mass (418) capable of moving only along the excitation axis.

**5.** The detection device according to one of claims 1 to 4, wherein the actuator is of the electrostatic, piezoelectric, or magnetic type.

**6.** The detection device according to one of claims 1 to 5, wherein the detection means are of the capacitive, piezoelectric, magnetic, piezoresistive, frequency, or other type.

**7.** The detection device according to claim 6, wherein the detection means (10) comprise at least one piezoresistive gauge, and advantageously two piezoresistive gauges arranged on either side of the axis (Z) of the pivot link.

**8.** The detection device according to claim 7, wherein the second part (2.2) of the seismic mass (2) is capable of moving in a plane of the seismic mass (2), the suspension means (12) being formed by at least one spring deforming in the plane.

**9.** The detection device according to one of claims 1 to 7, wherein the second part (102.2) of the seismic mass (102) has a movement outside the plane of the seismic mass (102), the suspension means (112) being formed by at least one spring deforming out of plane.

**10.** The detection device according to one of claims 1 to 9, wherein the first part (2.1) forms a frame inside which the second part (2.2) is suspended.

**11.** The detection device according to one of claims 1 to 10, comprising two seismic masses (502) each comprising a first and a second part connected to each other and able to move relative to each other, the first parts being rigidly connected by an arm (530), the pivot link being made on the arm (530), and the detection means (510) detecting the movement of said arm, the two second mobile parts moving in phase relative to each other.

**12.** The detection device according to one of claims 1 to 10, comprising a seismic mass having at least first and second parts able to move relative to each other, the pivot link being made on the first part (402.1), the actuator (414) being arranged between the support and the second part (402.2) and being exerted thereon via an intermediate seismic mass (418) capable of moving only along the excitation axis, said two parts being positioned relative to each other so that the axis cutting the axis (Z) of the pivot link and passing through the center of gravity (G) of the mass, in the absence of excitation, is perpendicular to the direction of the force to be detected.

13. The detection device according to one of claims 1 to 12, wherein the at least one seismic mass (2) is suspended by a beam, the axis (Z) of the pivot link being substantially orthogonal to the device plane.

14. The detection device according to claim 13 in combination with claim 6, wherein the mechanical link between the piezoresistive gauge(s) (10) and the seismic mass (2) is situated on or as close as possible to the plane containing the center of gravity (G) and the axis of the pivot link (Z).

15. The measuring device according to one of claims 1 to 12, wherein the seismic mass (102) is suspended by a torsion shaft whereof the axis is contained in the plane.

16. The detection device according to one of claims 1 to 15, comprising counter-reaction electrodes (428) and/or electrodes for adjusting the resonance frequency (428).

17. An accelerometer formed by a force measuring device according to one of claims 1 to 16.

18. The accelerometer according to claim 17, comprising electrodes for compensating quadrature bias on which a direct voltage and an alternating voltage are applied at a frequency that is twice the excitation frequency.

19. The accelerometer according to claim 17 or 18, being implemented under vacuum.

# FIG. 1A

# FIG.1B

FIG. 2A

FIG.2B

A3

302

306

310

306

302.2

302.1

X

a

Z

X

Y

## FIG. 3

Z

X

Y

A4

428

402.2

427

418

416

427

402

426

422

420

410

402.1

412

412

428

## FIG. 4

A5

502

530

G

502.1

502.1

Z

X

Y

# FIG.5A

Z

530

# FIG.5B

FIG. 6A

FIG. 6B

FIG. 7

808    806
804
802

**FIG. 8A**

810
808    808    806
804
802

**FIG. 8B**

812
810
804
802

**FIG. 8C**

FIG. 8D

FIG. 8E

FIG. 8F

## RÉFÉRENCES CITÉES DANS LA DESCRIPTION

**Documents brevets cités dans la description**

- US 20070084041 A
- EP 2098823 A

- EP 2098822 A


**Littérature non-brevet citée dans la description**

- **A. BARLIAN.** Raview: Semiconductor Piezoresistance for Mïcrosystems. *Proceedings of the IEEE,* 2009, vol. 97 (3), 513-552